Europäisches Patentamt

European Patent Office

Office européen des brevets

(19)

(11) **EP 0 986 179 B1**

(12) **FASCICULE DE BREVET EUROPEEN**

(45) Date de publication et mention
de la délivrance du brevet:
**20.04.2005 Bulletin 2005/16**

(51) Int Cl.⁷: **H03M 1/00**

(21) Numéro de dépôt: **99202833.2**

(22) Date de dépôt: **01.09.1999**

(54) **Procédé de recherche du point le plus proche d'un signal analogique dans un ensemble de points répartis non uniformement**

Suchverfahren des einem analogen Signal am nächsten liegenden Nachbarn in einem Satz von ungleichmässig verteilten Punkten

Method for searching out the nearest neighbour to an analogue signal value within a set of non-uniformly distributed points

(84) Etats contractants désignés:
**DE FR GB**

(30) Priorité: **08.09.1998 FR 9811182**

(43) Date de publication de la demande:
**15.03.2000 Bulletin 2000/11**

(73) Titulaire: **Koninklijke Philips Electronics N.V.
5621 BA Eindhoven (NL)**

(72) Inventeurs:
• **Chouly, Antoine
75008 Paris (FR)**
• **Brun, Véronique
75008 Paris (FR)**

(74) Mandataire: **Charpail, François et al
Société Civile S.P.I.D.
156, Boulevard Haussmann
75008 Paris (FR)**

(56) Documents cités:
**EP-A- 0 643 492        US-A- 4 907 276**

**Description**

L'invention concerne un procédé de recherche, dans un ensemble de points répartis non-uniformément, du point le plus proche d'une caractéristique d'un signal analogique donné. L'invention concerne également un récepteur comportant des moyens de réception d'un signal analogique et des moyens de décodage pour sélectionner dans un ensemble de points répartis non uniformément, le point le plus proche d'une caractéristique du signal reçu. Elle comporte enfin un système de transmission comportant un tel récepteur.

L'invention a d'importantes applications, notamment pour les modems de type PCM (de l'anglais Pulse Coded Modulation), et en particulier pour les modems conformes à la recommandation V.90 de l'ITU (de l'anglais International Telecommunication Union).

Le brevet US 4,143,363 décrit une méthode pour déterminer le niveau de quantification associé à un signal analogique par application d'une loi de compression logarithmique linéaire par segments. Cela revient à déterminer parmi un ensemble de niveaux non-uniformément répartis, le niveau le plus proche de l'amplitude du signal analogique reçu. La méthode proposée tient compte de certaines propriétés de la loi de compression utilisée : en particulier, elle tient compte du fait que les segments linéaires contiennent chacun un même nombre de points.

Cette méthode n'est pas générale : elle est liée à la loi de répartition des points dans l'ensemble considéré. En particulier elle n'est pas applicable à la détection des symboles reçus par un modem VPCM parce que les constellations utilisées par les modems PCM ne contiennent que certains points d'une loi de compression logarithmique linéaire par segments.

L'invention a notamment pour but de proposer une méthode efficace pour déterminer, dans un ensemble quelconque de points répartis non-uniformément, le point le plus proche d'une caractéristique d'un signal analogique donné.

Ce but est atteint avec un procédé tel que décrit dans la revendication 1 de la présente demande. La solution proposée consiste à effectuer une dichotomie sur le nombre de points contenu dans l'intervalle de recherche. Elle est indépendante de la loi de répartition des points dans l'ensemble de recherche considéré.

L'invention sera mieux comprise et d'autres détails apparaîtront à la lumière de la description qui va suivre en regard des dessins annexés qui sont donnés à titre d'exemples non limitatifs et dans lesquels :

- la figure 1 représente un exemple de système de transmission selon l'invention,
- la figure 2 représente, une loi de compression logarithmique,
- la figure 3 représente un exemple de constellation utilisée par des modems PCM,
- la figure 4 représente un organigramme d'un exemple de procédé selon l'invention,
- la figure 5 est un schéma en blocs d'un exemple de récepteur selon l'invention.

Les modems PCM permettent d'interconnecter un utilisateur A relié à un réseau de transmission par une liaison analogique et un utilisateur B relié au même réseau par une liaison numérique. Il peut s'agir par exemple d'un terminal utilisateur A communiquant avec un serveur d'informations B d'un fournisseur de services.

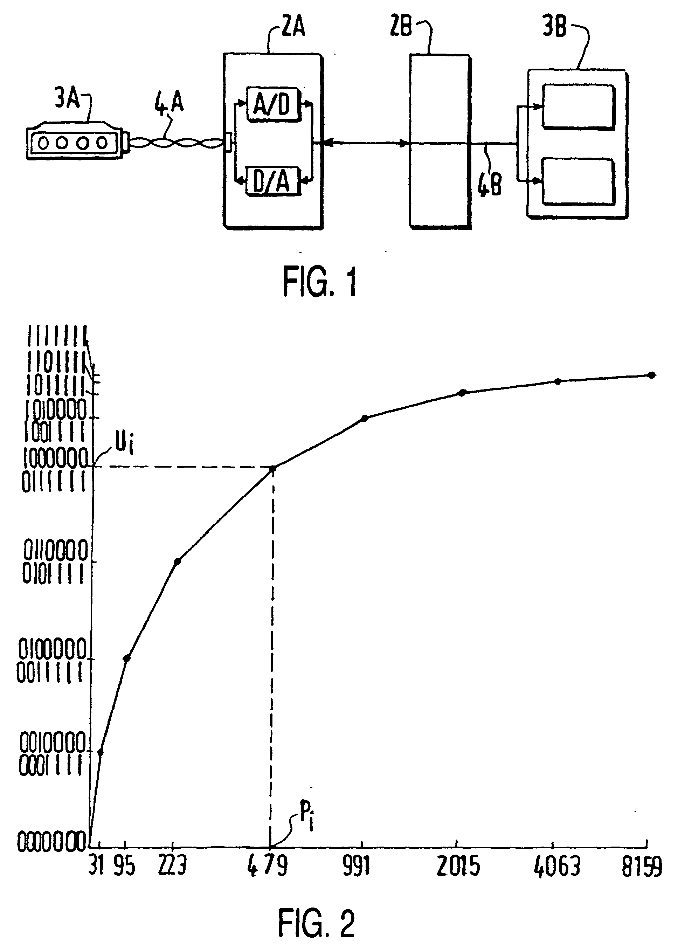

Sur la figure 1 on a représenté un exemple d'un tel système de transmission. Le système de transmission de la figure 1 comporte un réseau numérique de télécommunications 1 comprenant deux commutateurs 2A et 2B. Un modem PCM 3A est connecté au commutateur 2A par l'intermédiaire d'une paire torsadée 4A pour transmettre des signaux analogiques. Un modem PCM 3B est relié au commutateur 2B par l'intermédiaire d'une liaison numérique 4B, par exemple une liaison RNIS (Réseau numérique à Intégration de Services). Cette liaison numérique 4B peut être considérée comme une extension du réseau de transmission numérique : le commutateur 2B joue alors le rôle de répéteur.

Conformément à la recommandation V.90, les modems PCM utilisent des constellations constituées de points d'une loi de compression logarithmique linéaire par segments connue sous le nom de loi en A ou en μ. Ces points sélectionnés dans la loi sont appelés symboles de la constellation.

Les lois logarithmiques linéaires par segments en A ou en μ ont été introduites à l'origine dans les convertisseurs analogique / numérique et numérique / analogique des commutateurs numériques des réseaux téléphoniques pour la transmission de la voix. Elles permettent d'obtenir une quantification non uniforme de l'amplitude du signal à transmettre afin de garantir un rapport signal à bruit constant quelle que soit l'amplitude considérée (les niveaux de quantification sont d'autant plus serrés qu'on se rapproche de l'origine).

A titre d'exemple on a représenté schématiquement sur la figure 2 la partie positive d'une loi en μ. Elle se compose de 8 segments comprenant chacun 16 niveaux de quantification. A chaque niveau de quantification $U_i$ est associé un point $P_i$ par la loi en μ.

D'une façon générale, les symboles d'une constellation doivent être suffisamment espacés pour permettre de détecter les symboles reçus avec un taux d'erreur acceptable. Or les erreurs de détection sont plus sensibles sur les données que sur la voix (une erreur de détection sur des données se traduit par la restitution d'une donnée erronée, alors qu'une erreur de détection sur de la voix se traduit par une erreur sur le niveau sonore restitué). Il n'est en particulier pas possible d'utiliser tous les points de la loi en A ou en μ (adaptée à la transmission de la voix) pour former une constellation utilisée par des modems pour transmettre des données. C'est pour cette raison que seuls certains points de la loi en A ou en μ sont sélectionnés pour former les constellations utilisées par les modems VPCM.

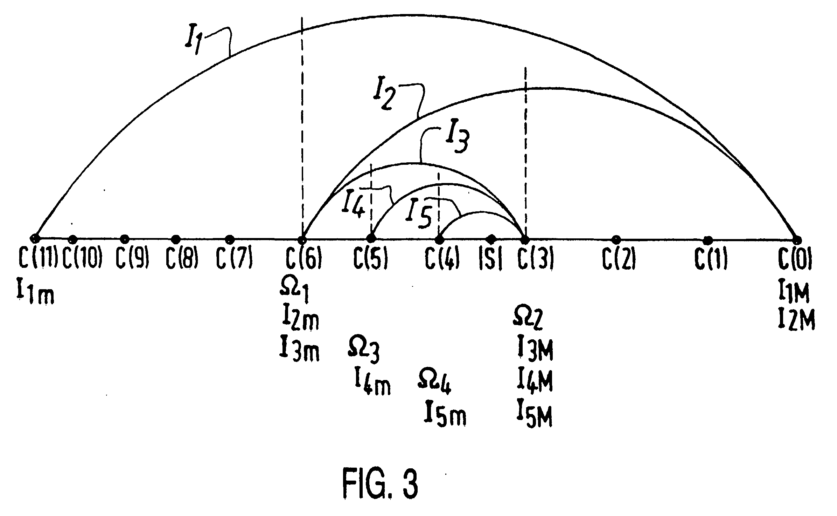

Sur la figure 3 on a représenté un exemple de constellation susceptible d'être utilisée par des modems PCM. Pour la simplicité de l'exposé, on s'est limité à une constellation de 12 symboles d'amplitude C(i) avec i=0,...,11. La constellation est organisée dans un ordre descendant, c'est-à-dire que l'indice le plus faible i=0 se réfère au point de la constellation de plus grande amplitude C(0).

Dans une transmission descendante de B vers A, le modem B émet des mots binaires. Chaque mot binaire émis $U_i$ est associé à un symbole de la constellation utilisée. Ces mots binaires sont reçus par le convertisseur 2A et convertis en signaux analogiques en appliquant une loi d'expansion inverse de ladite loi de compression. Les signaux analogiques ainsi formés sont transmis sur la liaison 4A. Pour chaque signal reçu, le modem A doit ensuite retrouver dans la constellation utilisée le symbole le plus proche de l'amplitude du signal reçu, c'est-à-dire l'indice p qui vérifie :

$$|C(p)-|S\| = Min_{i \in \{0,...,k-1\}}|C(i)-|S\|$$

où k est le nombre de symboles de la constellation et |S| l'amplitude du signal reçu.

Conformément à l'invention, on considère pour cela des intervalles de recherche successifs $I_j$ centrés sur |S|. L'intervalle de recherche $I_{j+1}$ est obtenu en divisant l'intervalle de recherche $I_j$ en deux intervalles comportant un nombre de symboles égal à une unité près. L'intervalle $I_{j+1}$ est celui des deux intervalles obtenus qui comporte le point d'amplitude |S|.

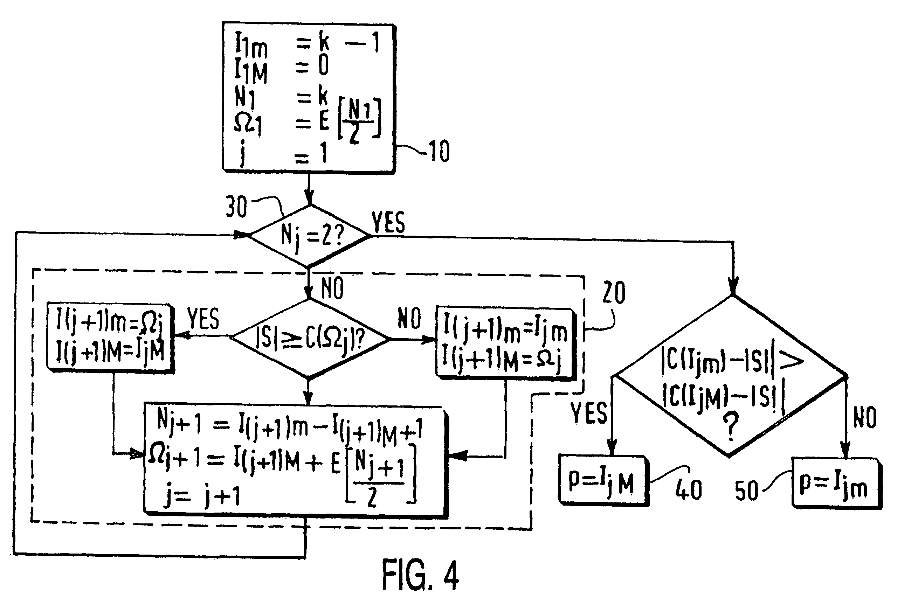

Un exemple de procédé de recherche selon l'invention va maintenant être décrit en regard de la figure 4. Pour cela :

- on définit un intervalle de recherche $I_j$ par l'indice jm du symbole de plus faible amplitude C(jm) contenu dans $I_j$, et par l'indice jM du symbole de plus grande amplitude C(jM) contenue dans $I_j$ :

$$I_j = [C(jm), C(jM)] \text{ avec } jm>jM$$

- on note $N_j$ le nombre de symboles de la constellation contenus dans l'intervalle de recherche $I_j$.
- on note $\Omega_j$ l'indice du symbole qui va être considéré comme symbole central pour diviser l'intervalle de recherche $I_j$ en deux. On choisit $\Omega_j = E(N_j/2)$ de façon à avoir le même nombre de symboles dans les deux intervalles lorsque c'est possible, c'est-à-dire lorsque $N_j$ est pair. Lorsque $N_j$ est impair l'un des deux intervalles comportera un symbole de plus que l'autre.

Le procédé de recherche est initialisé avec les valeurs suivantes (case 10) : $I_{1m}=k-1$, $I_{1M}=0$, $N_1=k$, $\Omega_1= E(N_1/2)$. Puis les intervalles de recherche successifs sont obtenus de la façon suivante pour $j \geqslant 1$ (case 20):

$$|S| \geq C(\Omega_j) \Rightarrow \begin{cases} I_{j+1} = \left[C(I_{(j+1)m}), C(I_{(j+1)M})\right] = \left[C(\Omega_j), C(I_{jM})\right] \\ Nj = I_{(j+1)m} - I_{(j+1)M} + 1 = \Omega_j - I_{jM} + 1 \\ \Omega_{j+1} = I_{(j+1)M} + E\left[\dfrac{N_{j+1}}{2}\right] = I_{jM} + E\left[\dfrac{N_{j+1}}{2}\right] \end{cases}$$

$$|S| < C(\Omega_j) \Rightarrow \begin{cases} I_{j+1} = \left[C(I_{(j+1)m}), C(I_{(j+1)M})\right] = \left[C(I_{jm}), C(\Omega_j)\right] \\ Nj = I_{(j+1)m} - I_{(j+1)M} + 1 = I_{jm} - \Omega_j + 1 \\ \Omega_{j+1} = I_{(j+1)M} + E\left[\dfrac{N_{j+1}}{2}\right] = \Omega_j + E\left[\dfrac{N_{j+1}}{2}\right] \end{cases}$$

Lorsque intervalle de recherche obtenu ne contient plus que deux symboles ($N_j$=2 ; case 30), l'indice recherché p est l'indice du symbole dont l'amplitude est la plus proche de |S|:

$$\text{si } |C(I_{jm})\text{-}|S|| > |C(I_{jM})\text{-}|S|| \text{ alors } p=I_{jM} \text{ (case 40)}$$

sinon, $p=I_{jm}$ (case 50).

Sur la figure 3 on a représenté les intervalles successifs de recherche $I_1$ à $I_5$ nécessaires pour déterminer l'indice p=3 du symbole dont l'amplitude C(3) est la plus proche de l'amplitude |S| du signal reçu.

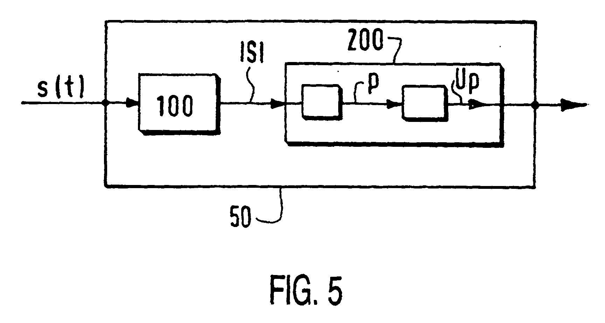

Sur la figure 5, on a représenté à titre d'exemple un schéma en blocs d'un exemple de récepteur 50 selon l'invention. Il comporte des moyens classiques 100 de réception de signaux analogiques et des moyens de décodage 200 pour sélectionner dans la constellation le symbole C(p) le plus proche en amplitude du signal reçu, et pour déterminer la séquence binaire $U_p$ émise par l'émetteur 3B et qui correspond à ce symbole conformément à la loi logarithmique utilisée. De façon avantageuse, ces moyens de décodage 200 sont constitués par des moyens classiques de calcul et de mémorisation.

Bien que l'invention ait été décrite dans le cadre de la norme V.90, elle n'est pas limitée à cette norme. D'une façon générale elle est applicable à la recherche du point le plus proche d'une caractéristique d'un signal reçu, dans un ensemble de points répartis de façon non-uniforme. La loi de répartition des points peut être quelconque.

## Revendications

1. Procédé de réception de signaux analogiques issus du codage de mots binaires par association desdits mots binaires à des symboles d'une constellation constituées de certains points seulement d'une loi de compression logarithmique linéaire par segments, ledit procédé comportant une étape de recherche, parmi les points de ladite constellation (C(i), i=0,...,k-1), du point le plus proche de l'amplitude (|S|) d'un signal analogique reçu, **caractérisé en ce que** ladite étape consiste à considérer des intervalles de recherche successifs ($I_j$) le long d'un axe portant les points de ladite constellation, lesdits intervalles de recherche successifs étant obtenus par découpage d'un intervalle de recherche en deux intervalles comportant un nombre de points égal à une unité près.

2. Récepteur(3A, 3B) comportant des moyens de réception (100) d'un signal analogique issus du codage de mots binaires par association desdits mots binaires à des symboles d'une constellation constituées de certains points seulement d'une loi de compression logarithmique linéaire par segments, ledit récepteur comportant des moyens de décodage (200) pour sélectionner parmi les points de ladite constellation, le point le plus proche de l'amplitude d'un signal analogique reçu, **caractérisé en ce que** lesdits moyens de décodage comportent des moyens d'élaboration d'intervalles de recherche successifs ($I_j$) le long d'un axe portant les points de ladite constellation, lesdits intervalles de recherche successifs étant obtenus par découpage d'un intervalle de recherche en deux intervalles comportant un nombre de points égal à une unité près.

3. Récepteur selon la revendication 2, **caractérisé en ce que** lesdits moyens d'élaboration comportent notamment des moyens pour déterminer un point dit point milieu d'un intervalle de recherche, à partir de la partie entière de la moitié du nombre de points contenus dans ledit intervalle.

4. Système de transmission comportant au moins un émetteur émettre des signaux, un réseau de transmission desdits signaux comportant au moins une partie de transmission analogique, et un récepteur selon l'une des revendications 2 ou 3 pour recevoir des signaux analogiques.

**EP 0 986 179 B1**

**Patentansprüche**

1. Empfangsverfahren von Analogsignalen kommend aus der Kodierung binärer Wörter mit den Assoziation der besagten binären Wörter mit Symbolen einer nur aus bestimmten Punkten gebildeten Konstellation eines segmentierten linearen logarithmischen Kompressionsgesetzes, wobei das besagte Verfahren einen Suchschritt unter den Punkten der besagten Konstellation (C(i), i=0,...,k-1) desjenigen Punktes enthält, der am nächsten an der Amplitude (|S|) eines erhaltenen analogen Signals liegt, **dadurch gekennzeichnet, dass** der besagte Schritt darin besteht, aufeinander folgende Sucheintervalle (Ij) entlang einer Achse mit den Punkten der besagten Konstellation zu betrachten, während die besagten aufeinander folgende Sucheintervalle durch Teilung eines Suchintervalls in zwei Intervalle mit einer bis auf eine Einheit gleichen Anzahl an Punkten werden.

2. Empfänger (3A, 3B) mit Mitteln für den Empfang (100) eines analogen Signals kommend aus der Kodierung binärer Wörter durch Assoziation der besagten binären Wörter mit Symbolen einer nur aus bestimmten Punkten gebildeten Konstellation eines segmentierten linearen logarithmischen Kompressionsgesetzes, wobei der besagte Empfänger Dekodierungsmittel (200) für die Auswahl unter den Punkten der besagten Konstellation desjenigen Punktes enthält, der am nächsten an der Amplitude eines erhaltenen analogen Signals liegt, **dadurch gekennzeichnet, dass** die besagten Dekodierungsmittel Mittel für das Einbringen von aufeinander folgende Sucheintervalle (Ij) entlang einer Achse mit den Punkten der besagten Konstellation enthalten und die besagten aufeinander folgenden Suchintervalle durch Teilung eines Suchintervalls in zwei Intervalle mit einer bis auf eine Einheit gleichen Anzahl an Punkten erhalten werden.

3. Empfänger nach Anspruch 2, **dadurch gekennzeichnet, dass** die besagten Einbringungsmittel insbesondere Mittel zur Bestimmung eines Punktes mit der Bezeichnung Mittelpunkt eines Suchintervalls ausgehend vom Gesamtteil der Hälfte der Anzahl in dem besagten Intervall enthaltenen Punkte enthalten.

4. Übertragungssystem mit mindestens einem Sender zum Senden von Signalen, einem Netz für die Übertragung der besagten Signale mit mindestens einem analogen Übertragungsteil und einem Empfänger nach einem der Ansprüche 2 oder 3 für den Empfang von Analogsignalen.

**Claims**

1. A method of receiving analog signals obtained from encoding binary words by associating said binary words with constellation symbols constituted by only certain points of a segmented linear logarithmic compression law, said method comprising a step of searching, among the points of said constellation (C(i), i=0, ..., k-1), the point which is the nearest from the amplitude (|S|) of a received analog signal, **characterized in that** said step consists of considering successive search intervals ($I_j$) along an axis carrying the points of said constellation, said successive search intervals being obtained by splitting up a search interval into two intervals comprising a number of points which is equal or different by one.

2. A receiver (3A, 3B) comprising means (100) for receiving an analog signal obtained from encoding binary words by associating said binary words with constellation symbols constituted by only certain points of a segmented linear logarithmic compression law, said receiver comprising decoding means (200) for selecting, among the points of said constellation, the point which is the nearest from the amplitude of a received analog signal, **characterized in that** said decoding means comprise means for elaborating successive search intervals ($I_j$) along an axis carrying the points of said constellation, said successive search intervals being obtained by splitting up a search interval into two intervals comprising a number of points which is equal or different by one.

3. A receiver as claimed in claim 2, **characterized in that** said elaboration means particularly comprise means for determining a point, referred to as central point of a search interval, from the entire part of half the number of points comprised in said interval.

4. A transmission system comprising at least a transmitter for transmitting signals, a network for transmitting said signals, comprising at least an analog transmission part, and a receiver as claimed in claim 2 or 3 for receiving analog signals.

FIG. 1

FIG. 2

FIG. 3

EP 0 986 179 B1

FIG. 4

FIG. 5